# EUROPÄISCHE PATENTSCHRIFT

(11) **EP 3 189 586 B1**
(45) Veröffentlichungstag und Bekanntmachung des Hinweises auf die Patenterteilung: **03.06.2020**
(21) Anmeldenummer: 16787366.0
(22) Anmeldetag: 19.10.2016
(51) Int. Cl.: H02M 7/00, H05G 1/10

(54) **SCHALTUNGSANORDNUNG ZUR REDUZIERUNG DER MAXIMALEN ELEKTRISCHEN FELDSTÄRKE, HOCHSPANNUNGSERZEUGUNGSEINHEIT MIT EINER DERARTIGEN SCHALTUNGSANORDNUNG UND RÖNTGENGENERATOR MIT EINER DERARTIGEN HOCHSPANNUNGSERZEUGUNGSEINHEIT**
CIRCUIT ARRANGEMENT FOR REDUCING THE MAXIMUM ELECTRIC FIELD STRENGTH, HIGH-VOLTAGE-GENERATION UNIT COMPRISING SUCH A CIRCUIT ARRANGEMENT, AND X-RAY GENERATOR COMPRISING SUCH A HIGH-VOLTAGE-GENERATION UNIT
CIRCUIT DE RÉDUCTION DE L'INTENSITÉ DE CHAMP ÉLECTRIQUE MAXIMALE, UNITÉ DE GÉNÉRATION DE HAUTE TENSION POURVUE D'UN CIRCUIT DE CE GENRE ET GÉNÉRATEUR DE RAYONS X POURVU D'UNE UNITÉ DE GÉNÉRATION DE HAUTE TENSION DE CE GENRE

(30) Priorität: 27.11.2015 DE 102015223534
(43) Veröffentlichungstag der Anmeldung: 12.07.2017
(73) Patentinhaber: Siemens Healthcare GmbH, 91052 Erlangen (DE)
(72) Erfinder: BEYERLEIN, Walter, 91088 Bubenreuth (DE); EICHHORN, Richard, 96114 Hirschaid seigendorf (DE); HOFFMANN, Christian, 90419 Nürnberg (DE); HOFFMANN, Norbert, 90491 Nürnberg (DE); KARIMI, Rashid, 91052 Erlangen (DE)
(86) Internationale Anmeldenummer: PCT/EP2016/075009
(87) Internationale Veröffentlichungsnummer: WO 2017/089030

(56) Entgegenhaltungen:
- WO-A1-2015/131931
- WO-A1-2017/089030
- WO-A2-2011/151767
- DE-A1-102007 032 808
- DE-A1-102013 223 538
- US-A1- 2006 007 624

## Beschreibung

Schaltungsanordnung zur Reduzierung der maximalen elektrischen Feldstärke, Hochspannungserzeugungseinheit mit einer derartigen Schaltungsanordnung und Röntgengenerator mit einer derartigen Hochspannungserzeugungseinheit

### Gebiet der Erfindung

Die Erfindung betrifft eine Schaltungsanordnung zur Reduzierung der durch eine Hochspannung erzeugten, maximalen elektrischen Feldstärke von ersten elektronischen Bauelementen, die auf einer Leiterplatte angeordnet sind und auf Hochspannungspotenzial liegen, und eine Hochspannungserzeugungseinheit mit einer derartigen Schaltungsanordnung.

### Hintergrund der Erfindung

Bei einer Schaltungsanordnung, bei der in Bezug auf ein Bezugspotenzial (beispielsweise Masse) elektronische Bauelemente auf Hochspannung liegen, treten hohe elektrische Feldstärken zwischen den elektronischen Bauelementen und dem Bezugspotenzial auf. Im Folgenden wird unter "elektronisches Bauelement" ein "elektronisches oder elektrisches Bauelement" verstanden.

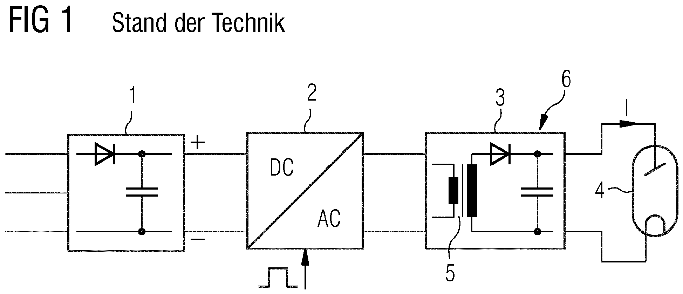

Hochspannungsschaltungsanordnungen kommen beispielsweise bei Röntgengeneratoren zum Einsatz. Röntgengeneratoren benötigen zur Erzeugung einer Röntgenstrahlung eine Beschleunigungsspannung, die unipolar (maximal + oder - 150 kV) oder bipolar (symmetrisch maximal -75 und +75 kV) zwischen der Anode und der Kathode anliegt. Die Hochspannungserzeugungskette der Röntgengeneratoren (Hochfrequenz- oder Multipulsgeneratoren) bestehen, wie in **Fig. 1** dargestellt, aus einem Netzeingang 1, einem Schwingkreiswechselrichter 2 (Inverter) und einer Hochspannungserzeugungseinheit 3, die einem Röntgenstrahler 4 die benötigte Hochspannung zur Verfügung stellt.

Hochspannungserzeugungseinheiten 3 weisen in der Regel einen ölgefüllten Kessel auf, in dem einer oder mehrere Hochspannungstransformatoren 5, eine einfache oder mehrstufige (Kaskade) Gleichrichterschaltung 6, ein Element zur Dämpfung von transienten Vorgängen (resistiv oder induktiv) und ein Messteiler zur Bestimmung der Hochspannung angeordnet sind. Moderne Hochspannungserzeuger 3 weisen Schaltungen auf, die eine kombinierte Gleichrichtung und Vervielfachung der Hochspannung ermöglichen (z.B. Villard-, Greinacher-, Delon-Schaltung).

Die bekannten Schaltungen sind nicht für die Verwendung auf Hochspannungspotential ausgelegt. Sind metallische Spitzen, Ecken oder Kanten bei Hochspannungskomponenten vorhanden, so werden lokal hohe Feldstärken erzeugt, die die elektrischen Festigkeitswerte der umgebenen Isoliermedien überschreiten können. Ist dies der Fall, so können ungewollte Entladungen, Überschläge oder Durchschläge von diesen Stellen ausgelöst werden, die von einer kurzzeitigen Betriebsstörung bis zum Ausfall des Hochspannungserzeugers bzw. des Röntgengenerators führen können.

In der Offenlegungsschrift DE 10 2007 032 808 A1 werden Lösungen zur Reduzierung der elektrischen Feldstärke und Anpassung der parasitären Kapazitäten von Hochspannungskomponenten offenbart. Insbesondere wird vorgeschlagen, zwei leitende bzw. leitfähige Platten schräg zu einer Diodenkette der Hochspannungserzeugungseinheit auf der Leiterplatte anzuordnen.

Die US 2006/0007624 A1 beschreibt eine Anordnung zur Reduktion von elektrischen Entladungen auf einer Leiterplatte mittels einer leitenden Metallplatte.

Die WO 2011/151767 A2 beschreibt die Anordnung von Push-Pull-und Buffer-Kondensatoren auf Leiterplatten eines Spannungsgleichrichters.

Die DE 10 2013 223538 A1 beschreibt eine Schaltungsanordnung und ein Verfahren zum Erzeugen einer Zwischenkreisspannung für einen Wechselrichter.

### Zusammenfassung der Erfindung

Die vorliegende Erfindung stellt gemäß Anspruch eine Schaltungsanordnung mit elektronischen ersten Bauelementen, die auf einer Leiterplatte angeordnet sind und auf Hochspannungspotenzial liegen, bereit. Ferner betrifft die Erfindung eine Hochspannungserzeugungseinheit gemäß Anspruch 9 und einen Röntgengenerator gemäß Anspruch 10. Bevorzugte Ausführungsformen sind in den abhängigen Ansprüchen definiert.

Es ist Aufgabe der Erfindung, eine Schaltungsanordnung, eine Hochspannungserzeugungseinheit und einen Röntgengenerator anzugeben, die das maximale elektrische Feld reduzieren und so die Ausfallwahrscheinlichkeit verbessern.

Gemäß der Erfindung wird die gestellte Aufgabe mit der Schaltungsanordnung, der Hochspannungserzeugungseinheit und dem Röntgengenerator der unabhängigen Patentansprüche gelöst. Vorteilhafte Weiterbildungen sind in den abhängigen Ansprüchen angegeben.

Erfindungsgemäß werden in der Nachbarschaft von hochspannungsführenden, elektronischen Bauelementen zusätzliche elektronische Bauelemente auf der Leiterplatte angeordnet, die auf Hochspannungspotenzial liegen, kurzgeschlossen sind und durch ihre Lage in der Nähe der elektronischen Bauelement die maximale elektrische Feldstärke zwischen den elektronischen Bauelementen und einem Bezugspotenzial verringern. Benachbart heißt im Abstand von weniger als zehn Millimeter.

Die physikalische Größe elektrische Feldstärke beschreibt die Stärke und Richtung eines elektrischen Feldes, also die Fähigkeit dieses Feldes, Kraft auf Ladungen auszuüben. Eine elektrische Feldstärke tritt immer zwischen Punkten unterschiedlichen elektrischen Potenzials auf.

Die Erfindung beansprucht eine Schaltungsanordnung mit elektronischen ersten Bauelementen, die auf einer Leiterplatte angeordnet sind und auf Hochspannungspotenzial liegen. Die Anordnung weist ferner auf:
- auf Hochspannungspotenzial liegende, funktionslose, elektronische zweite Bauelemente,
- die auf der Leiterplatte benachbart zu den elektronischen ersten Bauelementen angeordnet sind und
- die maximale elektrische Feldstärke zwischen den ersten Bauelementen und einem Bezugspotenzial und/oder zwischen Lötflächen der Leiterplatte und dem Bezugspotenzial reduzieren,
- wobei die zweiten Bauelemente Kondensatoren sind, welche kurzgeschlossen sind.

Durch die zusätzlichen, funktionslosen Bauelemente wird die maximale elektrische Feldstärke zwischen elektronischen Bauelementen auf Hochspannung und einem Bezugspotenzial reduziert.

In einer weiteren Ausgestaltung können die zweiten Bauelemente an Stellen angeordnet sein, an denen die maximale elektrische Feldstärke auftritt.

In einer bevorzugten Ausführungsform können die ersten und die zweiten Bauelemente smd-Bauelemente sein.

In einer weiteren Ausprägung können die ersten Bauelemente Dioden sein.

In einer weiteren Ausführungsform kann das Bezugspotenzial eine Gehäusemasse sein.

In einer weiteren Ausgestaltung können die zweiten Bauelemente kreisbogensegmentförmig angeordnet sein.

Des Weiteren kann die Schaltungsanordnung auf Hochspannungspotenzial liegende Durchkontaktierungen in der Leiterplatte benachbart zu den zweiten Bauelementen aufweisen. Dadurch wird die Feldreduzierung weiter verbessert.

In einer Weiterbildung können Lötflächen auf der Leiterplatte zur Kontaktierung der ersten Bauelemente vollständig von den ersten Bauelementen verdeckt sein, wodurch die Feldsteuerung weiter verbessert wird.

Die Erfindung beansprucht auch eine Hochspannungserzeugungseinheit mit mindestens einem Hochspannungstransformator und einer mit dem Hochspannungstransformator elektrisch verbundenen erfindungsgemäßen Schaltungsanordnung zur Gleichrichtung einer Hochspannung.

Außerdem beansprucht die Erfindung einen Röntgengenerator mit einem Schwingkreiswechselrichter und einer erfindungsgemäßen Hochspannungserzeugungseinheit.

Weitere Besonderheiten und Vorteile der Erfindung werden aus den nachfolgenden Erläuterungen mehrerer Ausführungsbeispiele anhand von schematischen Zeichnungen ersichtlich.

Es zeigen:
- Fig. 1:: eine Schaltungsanordnung eines Röntgengenerators gemäß Stand der Technik,
- Fig. 2:: eine Schaltungsanordnung mit feldsteuernden Bauelementen,
- Fig. 3:: eine Schaltungsanordnung mit feldsteuernden Bauelementen und feldsteuernden Durchkontaktierungen,
- Fig. 4:: eine Schaltungsanordnung mit kreisbogenförmig angeordneten, feldsteuernden Bauelementen und
- Fig. 5:: ein Schaubild der elektrischen Feldstärke.

### Detaillierte Beschreibung mehrerer Ausführungsbeispiele

Die Erfindung soll beispielhaft für eine Diodenbaugruppe einer Hochspannungserzeugungseinheit beschrieben werden. Die Diodenbaugruppe ist für die Gleichrichtung der Hochspannung verantwortlich.

Lötflächen (auch mit Pads bezeichnet) mit Dicken im Bereich von 35pm auf den Leiterplatten dienen zur Kontaktierung von elektronischen Bauelementen. Die Lötflächen haben oftmals scharfe metallische Kanten, die für Hochspannungsentladungen verantwortlich sein können. Der innere Aufbau von Dioden und deren Kontaktierungen bestehen u.a. aus kostenoptimierten Stanzteilen im Millimeterbereich mit mikroskopischen Spitzen und Kanten, die wiederum hohe Toleranzen aufweisen können. Durch die smd-Technologie sind die Geometrien der Lötflächen für die Bauelemente vorgegeben, so dass scharfkantige Strukturen an den Lötflächen und an den Dioden entstehen, die bei hohen elektrischen Spannungen zu Entladungen im Isoliersystem in Bezug auf ein Bezugspotenzial führen können.

Bei einer Feldsimulation mittels FEM der elektrischen Feldstärke an einem Modell einer Flachbaugruppe mit Dioden wurde deutlich, dass an den Kanten der Dioden bzw. an den Rändern den Lötflächen eine maximale elektrische Feldstärke von etwa 23 kV/mm auftreten kann.

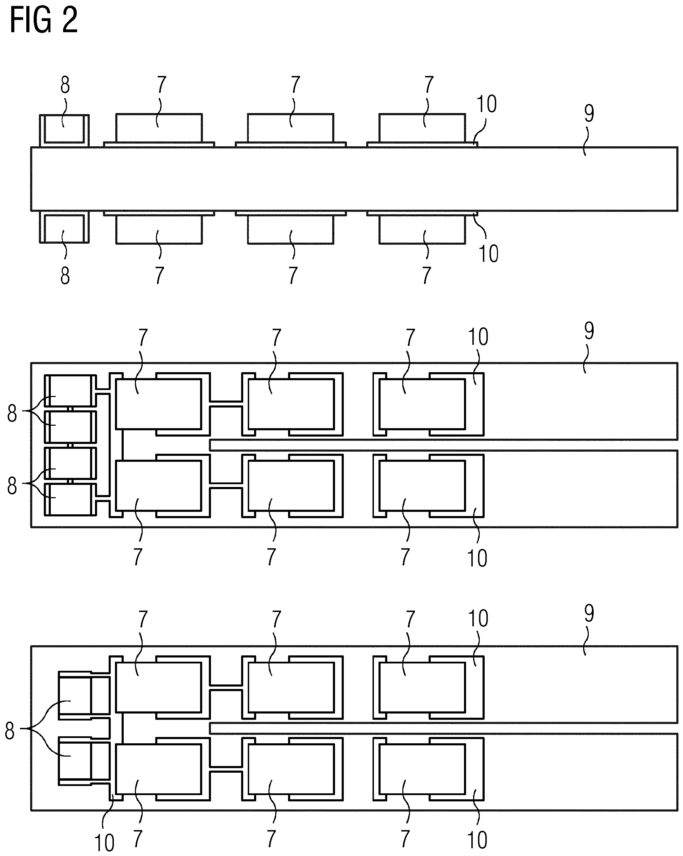

In **Fig. 2** ist dargestellt, wie bei einer smd-Flachbaugruppe mit Dioden 7 (= elektronische erste Bauelemente) zur Gleichrichtung, die auf Hochspannungspotenzial betrieben werden, eine Feldsteuerung (= Reduzierung der maximalen elektrischen Feldstärke) kostengünstig und platzsparend erfolgen kann.

**Fig. 2** zeigt oben einen Querschnitt durch eine Leiterplatte 9 mit Dioden 7 und die dazugehörige Draufsicht in der Mitte. Zur Feldsteuerung werden zusätzlich zu den Dioden 7 vier elektronische zweite Bauelemente 8, vorzugsweise Kondensatoren, ohne Funktion mit ausgewählten Geometrien zur Feldsteuerung an die kritischen Stellen auf der Leiterplatte 9 benachbart zu den Dioden 7 angebracht. Bevorzugt werden Kondensatoren oder Widerstände in den smd-Baugrößen (1210, 1206, 0805, 0603...) stirnseitig zu den letzten Dioden 7 angebracht. Unten in **Fig. 2** ist eine Draufsicht mit zwei zweiten Bauelementen 8 dargestellt, die ebenfalls stirnseitig angeordnet sind.

Als besonders vorteilhaft zeigen sich Kondensatoren in der Bauform 0805 (Länge = 2,0mm, Breite = 0,8mm, Höhe = 1,25mm), da diese große metallische Anschlüsse aufweisen, die der Homogenisierung des elektrischen Feldes dienen. Die zweiten Bauelemente 8 können je nach Bedarf als Kette oder einzeln seitlich oder stirnseitig zur Umgebung angebracht werden. Die zweiten Bauelemente 8 weisen keine Funktion auf und sind kurzgeschlossen.

MLCC-Kondensatoren eignen sich aufgrund der inneren Struktur besonders für eine seitliche Einbringung. Die metallischen Flächen zur Erhöhung der inneren Kapazität nehmen das Potenzial der beiden Kontakte ein und homogenisieren somit das elektrische Feld.

Zusätzlich kann die Feldsteuerung mit zur Umgebung verdeckten Lötflächen 10 verbessert werden, indem die ersten Bauelemente (Dioden 7) etwas überstehen und somit die scharfen Kanten der Lötflächen 10 verdecken.

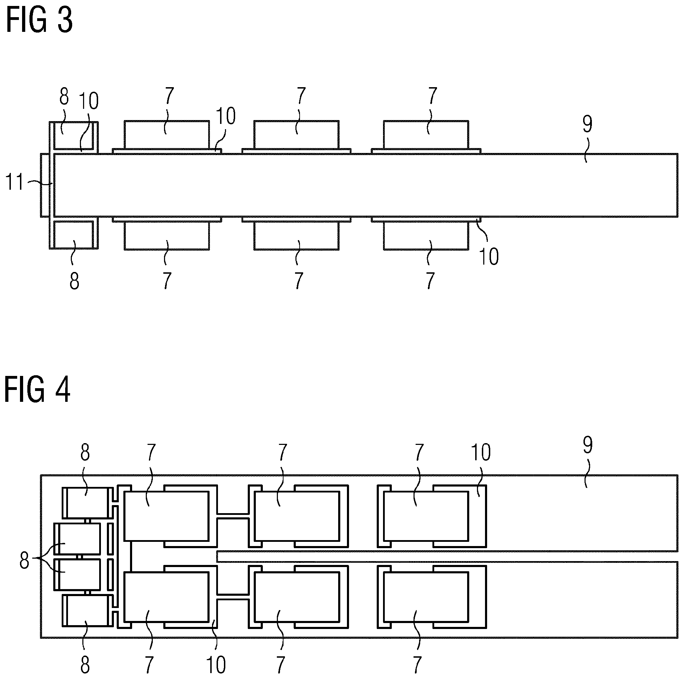

In **Fig. 3** ist eine Flachbaugruppe mit einer Leiterplatte 9 im Querschnitt dargestellt, bei der zusätzlich zu den zweiten Bauelementen 8 und den Dioden 7 Durchkontaktierungen 11 (sogenannte Vias) an den äußeren Lötflächen 10 vorgesehen sind. Die Durchkontaktierungen 11 haben eine zusätzliche feldsteuernde Wirkung.

In **Fig. 4** ist eine Draufsicht auf einer Flachbaugruppe mit Dioden 7 und zweiten Bauelementen 8 auf einer Leiterplatte 9 dargestellt, bei der die feldsteuernden zweiten Bauelemente 8 stirnseitig, kreisbogenförmig angeordnet sind. Dadurch wird eine Rundung nachgebildet, die die maximale elektrische Feldstärke noch weiter reduziert.

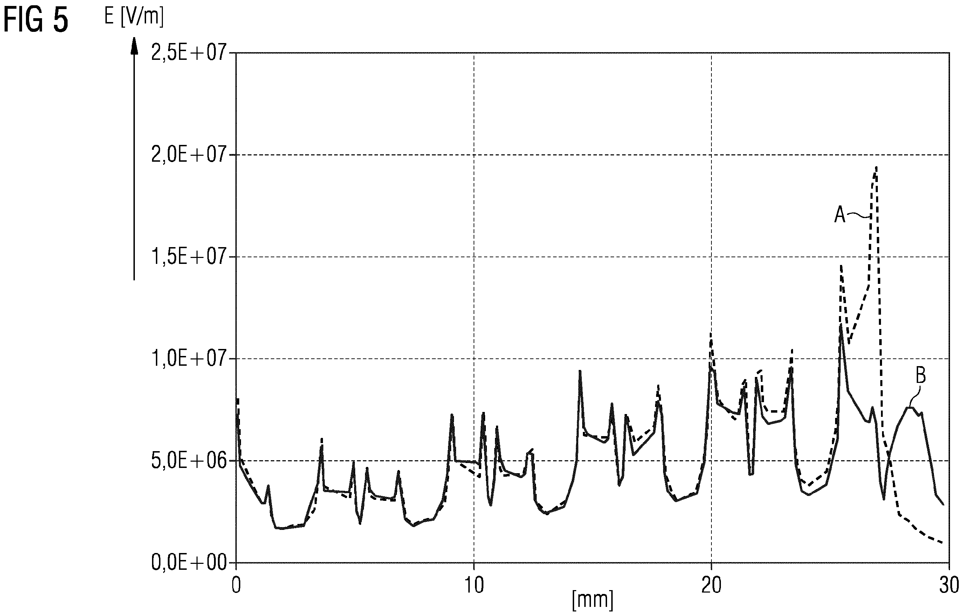

In **Fig. 5** ist in einem Schaubild der Feldsteuereffekt beispielhaft an einem Modell einer Diodenreihe mit 3x5 parallel angeordneten Dioden dargestellt, wobei alle Dioden auf einem Potential von +15 kV betrieben werden. Der kritische Abstand zu einer Gehäusewand auf Massepotenzial beträgt in dem Modell 25 mm. Zu sehen ist die erste Kurve A, die die elektrische Feldstärke E entlang der Diodenreihe ohne feldreduzierende zweite Bauelemente darstellt.

Werden nun fünf zweite Bauelemente (ohne ein Verrücken der smd-Dioden) stirnseitig zu der Diodenreihe ähnlich der Schaltungsanordnung in **Fig. 2** angebracht und auf das identische Hochspannungspotenzial +15 kV gesetzt, ergibt sich der mit der zweiten Kurve B dargestellte Verlauf der elektrischen Feldstärke E. Entlang der Diodenreihe werden identische Feldstärken E erreicht, während im Bereich der letzten Diode, benachbart zu den zweiten Bauelementen, zur Umgebung eine Reduzierung der Maximalfeldstärke von etwa 40 % (12 kV/mm statt 19 kV/mm) erreicht wird.

### Bezugszeichenliste

- 1: Netzeingang
- 2: Schwingkreiswechselrichter
- 3: Hochspannungserzeugungseinheit
- 4: Röntgenstrahler
- 5: Hochspannungstransformator
- 6: Gleichrichterschaltung
- 7: Diode (elektronisches erstes Bauelement)
- 8: elektronisches zweites Bauelement
- 9: Leiterplatte
- 10: Lötfläche
- 11: Durchkontaktierung

- A: erste Kurve
- B: zweite Kurve

## Patentansprüche

1. Schaltungsanordnung mit elektronischen ersten Bauelementen (7), die auf einer Leiterplatte (9) angeordnet sind und auf Hochspannungspotenzial liegen, beinhaltend:
- auf Hochspannungspotenzial liegende, funktionslose, elektronische zweite Bauelemente (8),
- die auf der Leiterplatte (9) benachbart zu den elektronischen ersten Bauelementen (7) angeordnet sind und dazu eingerichtet sind,
- die maximale elektrische Feldstärke (E) zwischen den ersten Bauelementen (7) und einem Bezugspotenzial und/oder zwischen Lötflächen (10) der Leiterplatte (9) und dem Bezugspotenzial zu reduzieren, wobei die zweiten Bauelemente (8) Kondensatoren sind,
**dadurch gekennzeichnet, dass** die Kondensatoren kurzgeschlossen sind.

2. Schaltungsanordnung nach Anspruch 1,
**dadurch gekennzeichnet,**
**dass** die zweiten Bauelemente (8) an Stellen angeordnet sind, wo die maximale elektrische Feldstärke (E) auftritt.

3. Schaltungsanordnung nach einem der Ansprüche 1 bis 2,
**dadurch gekennzeichnet,**
**dass** die ersten und zweiten Bauelemente (7, 8) smd-Bauelemente sind.

4. Schaltungsanordnung nach einem der vorhergehenden Ansprüche,
**dadurch gekennzeichnet,**
**dass** die ersten Bauelemente Dioden (7) sind.

5. Schaltungsanordnung nach einem der vorhergehenden Ansprüche,
**dadurch gekennzeichnet,**
**dass** das Bezugspotenzial eine Gehäusemasse ist.

6. Schaltungsanordnung nach einem der vorhergehenden Ansprüche,
**dadurch gekennzeichnet,**
**dass** die zweiten Bauelemente (8) kreisbogensegmentförmig angeordnet sind.

7. Schaltungsanordnung nach einem der vorhergehenden Ansprüche,
**gekennzeichnet durch:**
- auf Hochspannungspotenzial liegende Durchkontaktierungen (11) in der Leiterplatte (9) benachbart zu den zweiten Bauelementen (8).

8. Schaltungsanordnung nach einem der vorhergehenden Ansprüche,
**dadurch gekennzeichnet,**
**dass** Lötflächen (10) auf der Leiterplatte (9) zur Kontaktierung der ersten Bauelemente (7) so ausgebildet sind, dass die Lötflächen (10) vollständig von den ersten Bauelementen (7) verdeckt sind.

9. Hochspannungserzeugungseinheit (3) mit mindestens einem Hochspannungstransformator (5),
**gekennzeichnet durch:**
- einer mit dem Hochspannungstransformator (5) elektrisch verbundenen Schaltungsanordnung zur Gleichrichtung einer Hochspannung nach einem der vorhergehenden Ansprüche.

10. Röntgengenerator mit einem Schwingkreiswechselrichter (2),
**gekennzeichnet durch:**
- eine Hochspannungserzeugungseinheit (3) nach Anspruch 9.

## Claims

1. Circuit arrangement with electronic first components (7), which are arranged on a circuit board (9) and lie at high-voltage potential, containing:
- functionless, electronic second components (8) lying at high-voltage potential,
- which are arranged on the circuit board (9) adjacent to the electronic first components (7) and are configured
- to reduce the maximum electrical field strength (E) between the first components (7) and a reference potential and/or between pads (10) of the circuit board (9) and the reference potential, wherein the second components (8) are capacitors,
**characterised in that**
the capacitors are short-circuited.

2. Circuit arrangement according to claim 1,
**characterised in that**
the second components (8) are arranged at points where the maximum electrical field strength (E) occurs.

3. Circuit arrangement according to one of claims 1 to 2,
**characterised in that**
the first and second components (7, 8) are SMD components.

4. Circuit arrangement according to one of the preceding claims,
**characterised in that**
the first components are diodes (7).

5. Circuit arrangement according to one of the preceding claims,
**characterised in that**
the reference potential is a chassis ground.

6. Circuit arrangement according to one of the preceding claims,
**characterised in that**
the second components (8) are arranged on the shape of a circular arc.

7. Circuit arrangement according to one of the preceding claims,
**characterised by:**
- vias (11) lying at high-voltage potential in the circuit board (9) adjacent to the second components (8).

8. Circuit arrangement according to one of the preceding claims,
**characterised in that**
pads (10) are embodied on the circuit board (9) for contacting the first components (7) so that the pads (10) are completely covered by the first components (7).

9. High voltage generation unit (3) with at least one high-voltage transformer (5),
**characterised by:**
- a circuit arrangement for rectifying a high voltage electrically connected to the high-voltage transformer (5) according to one of the preceding claims.

10. X-ray generator with a parallel-tuned inverter (2),
**characterised by:**
- a high voltage generation unit (3) according to claim 9.

## Revendications

1. Montage comprenant des premiers composants (7) électroniques, qui sont mis sur une plaquette (9) à circuit imprimé et sont à un potentiel de haute tension, comportant :
- des deuxièmes composants (8) électroniques, sans fonction et à un potentiel de haute tension,
- qui sont mis sur la plaquette (9) à circuit imprimé au voisinage des premiers composants (7) électroniques et qui sont conçus
- pour réduire l'intensité (E) maximum du champ électrique entre les premiers composants (7) et un potentiel de référence et/ou entre des surfaces (10) de soudure de la plaquette (9) à circuit imprimé et le potentiel de référence, les deuxièmes composants (8) étant des condensateurs,
**caractérisé en ce que** les condensateurs sont court circuités.

2. Montage suivant la revendication 1,
**caractérisé**
**en ce que** les deuxièmes composants (8) sont mis en des emplacements où se produit l'intensité (E) maximum du champ électrique.

3. Montage suivant l'une des revendications 1 à 2,
**caractérisé**
**en ce que** les premiers et deuxièmes composants (7, 8) sont des composants smd.

4. Montage suivant l'une des revendications précédentes,
**caractérisé**
**en ce que** les premiers composants sont des diodes (7).

5. Montage suivant l'une des revendications précédentes,
**caractérisé**
**en ce que** le potentiel de référence est une masse de boîtier.

6. Montage suivant l'une des revendications précédentes,
**caractérisé**
**en ce que** les deuxièmes composants (8) sont disposés en forme de segments d'arc de cercle.

7. Montage suivant l'une des revendications précédentes,
**caractérisé par**
- des traversées (11) se trouvant à un potentiel de haute tension dans la plaquette (9) à circuit imprimé, au voisinage des deuxièmes composants (8).

8. Montage suivant l'une des revendications précédentes,
**caractérisé**
**en ce que** des surfaces (10) de soudure sont constituées sur la plaquette (9) à circuit imprimé pour la mise en contact des premiers composants (7), de manière à ce que les surfaces (10) de soudure soient recouvertes complètement par les premiers composants (7).

9. Unité (3) de production d'une haute tension, comprenant au moins un transformateur (5) de haute tension,
**caractérisée par**
- un montage relié électriquement au transformateur (5) de haute tension pour redresser une haute tension suivant l'une des revendications précédentes.

10. Générateur de rayons x ayant un onduleur (2) à circuit oscillant,
**caractérisé par**
- une unité (3) de production d'une haute tension suivant la revendication 9.
